# EUROPEAN PATENT APPLICATION

(11) **EP 4 625 727 A1**
(43) Date of publication of application: **01.10.2025**
(21) Application number: 24166090.1
(22) Date of filing: 25.03.2024
(51) Int. Cl.: H01S 5/065, H01S 5/0687, H01S 5/10, H01S 5/14, H01S 5/026, H01S 5/323

(54) **SEMICONDUCTOR TUNABLE RING LASER, PHOTONIC INTEGRATED CIRCUIT AND OPTO-ELECTRONIC SYSTEM COMPRISING THE SAME**

(71) Applicant: EFFECT Photonics B.V., 5656 AE Eindhoven (NL)
(72) Inventor: Kleijn, Emil, 5656AE Eindhoven (NL); Tahvili, Mohammad Saeed, 5656AE Eindhoven (NL)
(74) Representative: Kramer-Ograjensek, Petra

(57) **Abstract**

The invention relates to a semiconductor tunable ring laser (1) comprising a laser cavity (2) having a closed loop optical path, and an optical filter (3) that is arranged within the laser cavity and configured as a transmission-type optical filter if the semiconductor tunable ring laser is in use. The optical filter comprises a first MZI-based tunable frequency filter section (3a) comprising a first 2x2 MMI output splitter (9) having an x/(100-x) split ratio with x being unequal to 50. The first 2x2 MMI output splitter provides the laser cavity with an optical monitoring port that is presented with a first non-zero fraction, T₁, of optical radiation that is sufficient for wavelength locking and/or power monitoring outside the laser cavity.

The invention also relates to a PIC (100) comprising a semiconductor tunable ring laser according to the invention, and to an opto-electronic system (200) comprising such a PIC.

## Description

### FIELD OF THE INVENTION

The present invention relates to a semiconductor tunable ring laser. The invention also relates to a photonic integrated circuit (PIC) comprising the semiconductor tunable ring laser according to the invention. The invention further relates to an opto-electronic system comprising a PIC according to the invention. The opto-electronic system according to the invention can be used for example, but not exclusively, for telecommunication applications, Light Detection and Ranging (LIDAR) or sensor applications.

### BACKGROUND OF THE INVENTION

In many opto-electronic systems that can be used for example, but not exclusively, for telecommunication applications, Light Detection and Ranging (LIDAR) or sensor applications, a semiconductor laser is the key element for generating a stable beam of optical radiation with a narrow spectrum. Many different types of semiconductor lasers are known such as semiconductor tunable ring lasers that comprise a laser cavity having a closed loop optical path. An advantage of a semiconductor tunable ring laser compared to for example a distributed Bragg reflector laser or a Fabry-Perot laser is that the laser cavity of the semiconductor tunable ring laser renders on-chip reflectors or facet reflectors unnecessary for achieving stimulated emission of photons. This advantage of semiconductor tunable ring lasers is beneficial for design and fabrication related issues regarding advanced PICs and opto-electronic systems that require a reduced complexity.

To keep the lasing wavelength of known semiconductor tunable ring lasers stable, typically a control loop is required that comprises a sensor that can generate a sensor signal the control loop can act upon. Typically, the sensor is an optical sensor that can generate the sensor signal based on a small fraction of optical radiation that is tapped from an amount of optical radiation constituting a main optical output of a semiconductor tunable ring laser and is directed towards the sensor. Typically, the small fraction of optical radiation is a few percent of the main optical output of the semiconductor tunable ring laser. Tapping off the small fraction of optical radiation from the main optical output of the semiconductor tunable ring laser and directing the small fraction of optical power towards the sensor of the control loop for lasing wavelength stabilization purposes not only causes the main optical output not to be available in its entirety for an application the semiconductor tunable ring laser is used in but also gives rise to optical losses that result in a reduced overall efficiency of the semiconductor tunable ring laser.

Based on the above, there is a need for providing a semiconductor tunable ring laser having an improved overall efficiency despite tapping off a small fraction of optical radiation and any optical losses associated with lasing wavelength stabilization purposes.

### SUMMARY OF THE INVENTION

It is an object of the present invention to provide a semiconductor tunable ring laser having an improved overall efficiency as a result of which the semiconductor tunable ring laser according to the invention can pre-empt or at least reduce at least one of the above-mentioned and/or other disadvantages associated with known semiconductor tunable ring lasers.

It is another object of the present invention to provide a PIC comprising a semiconductor tunable ring laser according to the invention.

It is yet another object of the present invention to provide an opto-electronic system comprising a PIC according to the invention. The opto-electronic system according to the invention can be used for example, but not exclusively, for telecommunication applications, LIDAR or sensor applications.

Aspects of the present invention are set out in the accompanying independent and dependent claims. Features from the dependent claims may be combined with features from the independent claim as appropriate and not merely as explicitly set out in the claims. Furthermore, all features may be replaced with other technically equivalent features.

At least one of the abovementioned objects is achieved by a semiconductor tunable ring laser comprising:
- a laser cavity having a closed loop optical path; and
- an optical filter that is arranged within the laser cavity and is configured as a transmission-type optical filter if the semiconductor tunable ring laser is in use, the optical filter comprising:
   - a first MZI-based tunable frequency filter section that comprises:
      ∘ a first 1x2 MMI input splitter comprising a first multimode waveguide section that is provided with:
         ∘ a first optical input port that is arranged in optical communication with the closed loop optical path of the laser cavity;
         ∘ a first optical output port; and
         ∘ a second optical output port;
         the first multimode waveguide section being configured to achieve a 50/50 split ratio;
      ∘ a first 2x2 MMI output splitter comprising a second multimode waveguide section that is provided with:
         ∘ a second optical input port;
         ∘ a third optical input port;
         ∘ a third optical output port that is arranged in optical communication with the closed loop optical path of the laser cavity; and
         ∘ a fourth optical output port that is configured and arranged as an optical monitoring port of the laser cavity;
      ∘ a first optical guiding structure comprising a first optical waveguide that is arranged to optically interconnect the first optical output port of the 1x2 MMI input splitter and the second optical input port of the first 2x2 MMI output splitter, the first optical guiding structure being configured to provide a first optical path length between the first optical output port of the first 1x2 MMI input splitter and the second optical input port of the first 2x2 MMI output splitter; and
      ∘ a second optical guiding structure comprising a second optical waveguide that is arranged to optically interconnect the second optical output port of the first 1x2 MMI input splitter and the third optical input port of the first 2x2 MMI output splitter, the second optical guiding structure being configured to provide a second optical path length between the second optical output port of the first 1x2 MMI input splitter and the third optical input port of the first 2x2 MMI output splitter, the second optical path length being different than the first optical path length;
      wherein the second multimode waveguide section of the first 2x2 MMI output splitter is configured to achieve an x/(100-x) split ratio with x having a value that is unequal to 50, the x/(100-x) split ratio being chosen to enable, if the semiconductor tunable ring laser is in use and irrespective of a phase relationship between optical radiation at the second optical input port of the first 2x2 MMI output splitter and optical radiation at the third optical input port of the first 2x2 MMI output splitter:
         ▪ a first non-zero fraction, T₁, of optical radiation of an amount of optical radiation, T₀, that is incident on the second optical input port of the first 2x2 MMI output splitter and on the third optical input port of the first 2x2 MMI output splitter to be present at the fourth optical output port of the first 2x2 MMI output splitter, the first non-zero fraction, T₁, of optical radiation being sufficient to enable wavelength locking and/or power monitoring outside of the laser cavity; and
         ▪ a second fraction, T₂=1-T₁, of optical radiation of the amount of optical radiation, T₀, to be present at the third optical output port of the first 2x2 MMI output splitter and thereby remaining in the closed loop optical path of the laser cavity.

In this way, the semiconductor tunable ring laser according to the present invention enables tapping off the first non-zero fraction, T₁, of optical radiation directly from within the laser cavity instead of after or outside of the laser cavity, i.e. from an amount of optical radiation constituting a main optical output of a semiconductor tunable ring laser, as is done in semiconductor tunable ring lasers known in the art. Surprisingly, it was found that tapping off the first non-zero fraction, T₁, of optical radiation directly from within the laser cavity results in a reduction of overall optical losses of the semiconductor tunable ring laser according to the present invention compared to the overall optical losses of a semiconductor tunable ring laser known in the art from which the first non-zero fraction, T₁, of optical radiation is tapped off after or outside of the laser cavity. Hence, the semiconductor tunable ring laser according to the present invention has an improved overall efficiency compared to semiconductor tunable ring lasers known in the art despite tapping off the first non-zero fraction, T₁, of optical radiation and any optical losses related to lasing wavelength stabilization purposes.

An insight of the present invention is that the x/(100-x) split ratio, with x having a value that is unequal to 50, of the first 2x2 MMI output splitter enables the first non-zero fraction, T₁, of optical radiation to always be present at the fourth optical output port of the first 2x2 MMI output splitter irrespective of the phase relationship between optical radiation at the second optical input port of the first 2x2 MMI output splitter and optical radiation at the third optical input port of the first 2x2 MMI output splitter.

An advantage of the above-mentioned insight is that it is not required to include a dedicated optical radiation tapping structure inside the laser cavity that is configured and arranged to allow tapping off an amount of optical radiation from within the cavity for wavelength locking and/or power monitoring purposes outside of the laser cavity. The person skilled in the art will appreciate that including a dedicated optical radiation tapping structure would give rise to additional losses and potential harmful reflections which would decrease the overall efficiency of the semiconductor tunable ring laser.

Another advantage of the insight mentioned above is that a control loop for ensuring that a minimum amount of optical radiation is available for wavelength locking and/or power monitoring outside of the laser cavity is not required. As a result, less components are required for achieving lasing wavelength stabilization for a semiconductor tunable ring laser according to the present invention compared to semiconductor tunable ring lasers known in the art. To enable wavelength locking and/or power monitoring outside of the laser cavity, the first non-zero fraction, T₁, of optical radiation is sufficient if the first non-zero fraction, T₁, of optical radiation is for example in a range from 1% to 15% of the amount of optical radiation, T₀, that is incident on the second optical input port of the first 2x2 MMI output splitter and on the third optical input port of the first 2x2 MMI output splitter.

In an embodiment of the semiconductor tunable ring laser according to the invention, the value of x is in a range from 64 to 80. In this way, the x/(100-x) split ratio of the first 2x2 MMI output splitter can range from 64/36 to 80/20. As a result, the first MZI-based tunable frequency filter section has a maximum transmission that can range from 85% to 99% and a minimum transmission that can range from 1% to 15%.

In an exemplary embodiment of the semiconductor tunable ring laser according to the invention, the value of x is 72. In this case, the split ratio of the first 2x2 MMI output splitter is 72/28, and the first MZI-based tunable frequency filter section has a maximum transmission of 95% and a minimum transmission of 5%.

In an embodiment of the semiconductor tunable ring laser according to the invention, the optical filter comprises a second MZI-based tunable frequency filter section comprising:
- a second 1x2 MMI input splitter comprising a third multimode waveguide section that is provided with:
   - a fourth optical input port that is arranged in optical communication with the third optical output port of the first 2x2 MMI output splitter of the first MZI-based tunable frequency filter section and thereby in optical communication with the closed loop optical path of the laser cavity;
   - a fifth optical output port; and
   - a sixth optical output port;
   the third multimode waveguide section being configured to achieve a 50/50 split ratio;
- a first 2x1 MMI output combiner comprising a fourth multimode waveguide section that is provided with:
   - a fifth optical input port;
   - a sixth optical input port; and
   - a seventh optical output port that is arranged in optical communication with the closed loop optical path of the laser cavity;
- a third optical guiding structure comprising a third optical waveguide that is arranged to optically interconnect the fifth optical output port of the second 1x2 MMI input splitter and the fifth optical input port of the first 2x1 MMI output combiner, the third optical guiding structure being configured to provide a third optical path length between the fifth optical output port of the second 1x2 MMI input splitter and the fifth optical input port of the first 2x1 MMI output combiner; and
- a fourth optical guiding structure comprising a fourth optical waveguide that is arranged to optically interconnect the sixth optical output port of the second 1x2 MMI input splitter and the sixth optical input port of the first 2x1 MMI output combiner, the fourth optical guiding structure being configured to provide a fourth optical path length between the sixth optical output port of the second 1x2 MMI input splitter and the sixth optical input port of the first 2x1 MMI output combiner, the fourth optical path length being different than the third optical path length.

As a result of the first MZI-based tunable frequency filter section and the second MZI-based tunable frequency filter section, the above-described embodiment of the semiconductor tunable ring laser according to the present invention has an improved frequency tunability. This is advantageous for PICs and opto-electronic systems comprising the semiconductor tunable ring laser according to the present invention. Such PICs and opto-electronic systems can be used for example, but not exclusively, in telecommunication applications, Light Detection and Ranging (LIDAR) or sensor applications.

In an embodiment of the semiconductor tunable ring laser according to the invention, the optical filter comprises a third MZI-based tunable frequency filter section comprising:
- a third 1x2 MMI input splitter comprising a fifth multimode waveguide section that is provided with:
   - a seventh optical input port that is arranged in optical communication with the seventh optical output port of the first 2x1 MMI output combiner of the second MZI-based tunable frequency filter section and thereby in optical communication with the closed loop optical path of the laser cavity;
   - an eighth optical output port; and
   - a ninth optical output port;
   the fifth multimode waveguide section being configured to achieve a 50/50 split ratio;
- a second 2x1 MMI output combiner comprising a sixth multimode waveguide section that is provided with:
   - an eighth optical input port;
   - a ninth optical input port; and
   - a tenth optical output port that is arranged in optical communication with the closed loop optical path of the laser cavity;
- a fifth optical guiding structure comprising a fifth optical waveguide that is arranged to optically interconnect the eighth optical output port of the third 1x2 MMI input splitter and the eighth optical input port of the second 2x1 MMI output combiner, the fifth optical guiding structure being configured to provide a fifth optical path length between the eighth optical output port of the third 1x2 MMI input splitter and the eighth optical input port of the second 2x1 MMI output combiner; and
- a sixth optical guiding structure comprising a sixth optical waveguide that is arranged to optically interconnect the ninth optical output port of the third 1x2 MMI input splitter and the ninth optical input port of the second 2x1 MMI output combiner, the sixth optical guiding structure being configured to provide a sixth optical path length between the ninth optical output port of the third 1x2 MMI input splitter and the ninth optical input port of the second 2x1 MMI output combiner, the sixth optical path length being different than the fifth optical path length.

As a result of the first MZI-based tunable frequency filter section, the second MZI-based tunable frequency filter section and the third MZI-based tunable frequency filter section, the above-described embodiment of the semiconductor tunable ring laser according to the present invention has an even further improved frequency tunability. As a result, PICs and opto-electronic systems comprising the semiconductor tunable ring laser according to the above-described embodiment of the present invention can be used for more advanced applications in the field of for example, but not exclusively telecommunication, Light Detection and Ranging (LIDAR) or sensors.

In an embodiment of the semiconductor tunable ring laser according to the invention, the closed loop optical path of the laser cavity is provided with:
- a gain section comprising:
   ∘ a tenth optical input port that is arranged in optical communication with the tenth optical output port of the second 2x1 MMI output combiner of the third MZI-based tunable frequency filter section and thereby in optical communication with the closed loop optical path of the laser cavity; and
   ∘ an eleventh optical output port; and
- a second 2x2 MMI output splitter comprising a seventh multimode waveguide section that is provided with:
   ∘ an eleventh optical input port that is arranged in optical communication with the eleventh optical output port of the gain section and thereby in optical communication with the closed loop optical path of the laser cavity;
   ∘ a twelfth optical input port that is arranged in optical communication with an optical reflector that is arranged outside the closed loop optical path of the laser cavity;
   ∘ a twelfth optical output port that is arranged in optical communication with the first optical input port of the first 1x2 MMI input splitter of the first MZI-based tunable frequency filter section and thereby in optical communication with the closed loop optical path of the laser cavity; and
   ∘ a thirteenth optical output port that is configured and arranged to enable optical power to be coupled out of the laser cavity for being used in an application other than wavelength locking and/or power monitoring purposes.

The second 2x2 MMI output splitter can be configured to have any suitable split ratio depending on the requirements of an application the semiconductor tunable ring laser according to the present invention is used in.

In an embodiment of the semiconductor tunable ring laser according to the invention, the first MZI-based tunable frequency filter section is configured to have a first free spectral range, the second MZI-based tunable frequency filter section is configured to have a second free spectral range, and the third MZI-based tunable frequency filter section is configured to have a third free spectral range, the first free spectral range, the second free spectral range, and the third free spectral range being different from each other. In this way, the stability of the semiconductor tunable ring laser according to the present invention can be improved.

In an embodiment of the semiconductor tunable ring laser according to the invention, the semiconductor tunable ring laser is an InP-based tunable ring laser. The person skilled in the art will appreciate that InP-based semiconductor materials are the semiconductor materials of choice for fabricating a semiconductor tunable ring laser that can be used for example, but not exclusively, in telecommunication applications, Light Detection and Ranging (LIDAR) or sensor applications. InP-based technology enables monolithic integration of both active components such as for example light-generating and/or light-absorbing optical devices, and passive components such as for example light-guiding and/or light-switching optical devices, in one PIC on a single die.

According to another aspect of the present invention, a PIC is provided comprising a semiconductor tunable ring laser according to the invention, wherein the PIC is a hybrid integrated PIC or a monolithic integrated PIC. Based on the above, the person skilled in the art will appreciate that the PIC according to the invention can benefit from the advantages provided by the semiconductor tunable ring laser according to the present invention.

An advantage of a hybrid integrated PIC is that the semiconductor tunable ring laser can be an InP-based tunable ring laser that is combined with for example Sibased opto-electronic devices. Hence, the PIC according to the present invention can be used in any semiconductor technology domain such as in the domain of silicon photonics.

Another advantage of a hybrid integrated PIC according to the invention is that the semiconductor tunable ring laser can be exchanged. Exchange of the semiconductor tunable ring laser can be required for example in case of malfunction of the laser or after breakdown of the laser.

An advantage of a monolithic integrated PIC is that both active and passive opto-electronic devices can be integrated on the same semiconductor substrate, e.g. an InP-based substrate. Moreover, monolithic integration of active and passive optoelectronics devices can be less cumbersome and possibly requires less die area than hybrid integration of active and passive opto-electronic devices.

In an embodiment of the PIC according to the invention, the PIC comprises an optical radiation monitoring assembly that is optically connected with the fourth optical output port of the first 2x2 MMI output splitter of the first MZI-based tunable frequency filter section of the optical filter of the semiconductor tunable ring laser. The optical radiation monitoring assembly can be part of a control loop that is configured and arranged to control the optical performance of the semiconductor tunable ring laser according to the present invention.

In an exemplary embodiment of the PIC according to the invention, the optical radiation monitoring assembly comprises a wavelength locker that can be configured and arranged to stabilize the lasing wavelength of the semiconductor tunable ring laser according to the present invention using the first non-zero fraction, T₁, of optical radiation that, if the semiconductor tunable ring laser is in use, is present at the fourth optical output port of the first 2x2 MMI output splitter of the first MZI-based tunable frequency filter section of the intra-cavity optical filter of the semiconductor tunable ring laser.

According to yet another aspect of the present invention, an opto-electronic system is provided comprising a PIC according to the invention, wherein the opto-electronic system is one of a transmitter, a receiver, a transceiver, a coherent transmitter, a coherent receiver and a coherent transceiver. The opto-electronic system can for example, but not exclusively, be used for telecommunication applications, LIDAR or sensor applications. Based on the above, the person skilled in the art will appreciate that any one of the above-mentioned transmitters, receivers and transceivers can benefit from the advantages provided by the PIC according to the present invention that comprises the semiconductor tunable ring laser according to the present invention.

### BRIEF DESCRIPTION OF THE DRAWINGS

Further features and advantages of the invention will become apparent from the description of exemplary and non-limiting embodiments of a semiconductor tunable ring laser, a PIC, and an opto-electronic system according to the present invention.

The person skilled in the art will appreciate that the described embodiments of the semiconductor tunable ring laser, the PIC and the opto-electronic system are exemplary in nature only and not to be construed as limiting the scope of protection in any way. The person skilled in the art will realize that alternatives and equivalent embodiments of the semiconductor tunable ring laser, the PIC and the opto-electronic system can be conceived and reduced to practice without departing from the scope of protection of the present invention.

Reference will be made to the figures on the accompanying drawing sheets. The figures are schematic in nature and therefore not necessarily drawn to scale. Furthermore, equal reference numerals denote equal or similar parts. On the attached drawing sheets,
figure 1 shows a schematic top view of a first exemplary, non-limiting embodiment of the semiconductor tunable ring laser according to the present invention;
figure 2 shows a schematic top view of a second exemplary, non-limiting embodiment of the semiconductor tunable ring laser according to the present invention;
figure 3 shows a schematic top view of a third exemplary, non-limiting embodiment of the semiconductor tunable ring laser according to the present invention;
figure 4 shows a schematic representation of an output transmission as a function of phase difference of an MZI-based tunable frequency filter section that comprises a 1x2 MMI input splitter that is configured to achieve a 50/50 split ratio and a 2x1 MMI output combiner that is configured to achieve a 50/50 combining ratio;
figure 5 shows a schematic representation of an output transmission as a function of phase difference of an MZI-based tunable frequency filter section that comprises a 1x2 MMI input splitter that is configured to achieve a 50/50 split ratio and a 2x2 MMI output splitter that is configured to achieve a 72/28 split ratio;

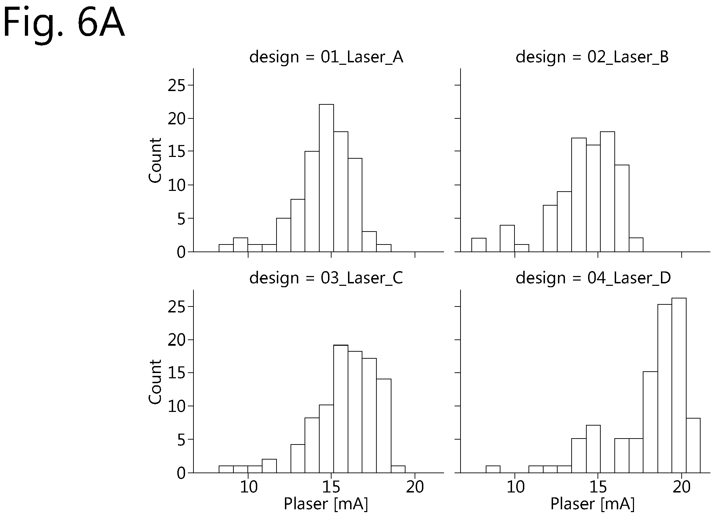

figure 6A shows a comparison of total optical output powers for three semiconductor tunable ring lasers A, B and C known in the art, wherein each of these known semiconductor tunable ring lasers comprises a conventional 85/15 output splitter that is arranged after or outside of the laser cavity to provide optical radiation that can be used for lasing wavelength stabilization purposes, and a semiconductor tunable ring laser D according to the present invention, wherein the laser cavity is directly tapped using a 2x2 MMI output splitter that is configured to achieve a 72/28 split ratio to provide optical radiation that can be used for lasing wavelength stabilization purposes;
figure 6B shows a comparison of total photo-induced electrical current for the three known semiconductor tunable ring lasers A, B and C, and the semiconductor tunable ring laser D according to the present invention, wherein the total photo-induced electrical current is a sum of the photo-induced electrical current as a result of the main optical output and the photo-induced electrical current as a result of a fraction of optical radiation that is directed to an optical sensor of a control circuit for stabilizing the lasing wavelength;
figure 7 shows a schematic top view of a first exemplary, non-limiting embodiment of a PIC according to the present invention that comprises the semiconductor tunable ring laser according to the present invention; and
figure 8 shows a schematic top view of a first exemplary, non-limiting embodiment of an opto-electronic system according to the present invention that comprises the PIC according to the present invention.

### DETAILED DESCRIPTION OF EMBODIMENTS

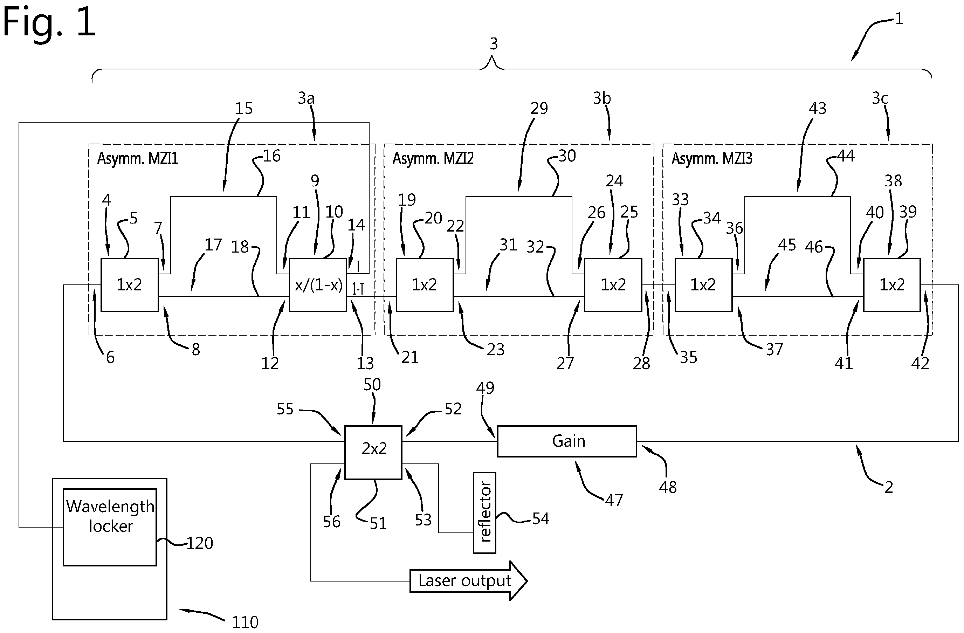

Figure 1 shows a schematic top view of a first exemplary, non-limiting embodiment of the semiconductor tunable ring laser 1 according to the present invention that comprises a laser cavity 2 having a closed loop optical path and an optical filter 3 that is arranged within the laser cavity 2. The optical filter 3 is configured as a transmission-type optical filter if the semiconductor tunable ring laser 1 is in use. The optical filter 3 comprises a first MZI-based tunable frequency filter section 3a, a second MZI-based tunable frequency filter section 3b and a third MZI-based tunable frequency filter section 3c that are arranged in a series configuration inside the laser cavity 2. The person skilled in the art will appreciate that the number of MZI-based tunable frequency filter sections is exemplary and non-limiting. Depending on the specific requirements the semiconductor tunable ring laser needs to meet, any suitable number, e.g. 1, 2, 3, 4, 5, 6, etc., can be envisaged.

The first MZI-based tunable frequency filter section 3a of the optical filter 3 shown in figure 1, comprises a first 1x2 MMI input splitter 4 comprising a first multimode waveguide section 5 that is provided with a first optical input port 6 that is arranged in optical communication with the closed loop optical path of the laser cavity 2, a first optical output port 7, and a second optical output port 8. The first multimode waveguide section 5 is configured to achieve a 50/50 split ratio. The first MZI-based tunable frequency filter section 3a further comprises a first 2x2 MMI output splitter 9 comprising a second multimode waveguide section 10 that is provided with a second optical input port 11, a third optical input port 12, a third optical output port 13 that is arranged in optical communication with the closed loop optical path of the laser cavity 2, and a fourth optical output port 14 that is configured and arranged as an optical monitoring port of the laser cavity 2. In accordance with the first exemplary, non-limiting embodiment of the semiconductor tunable ring laser 1 shown in figure 1, the fourth optical output port 14 is arranged in optical communication with a wavelength locker 120 of an optical radiation monitoring assembly 110.

The first optical output port 7 of the 1x2 MMI input splitter 4 and the second optical input port 11 of the first 2x2 MMI output splitter 9 are optically interconnected via a first optical guiding structure 15 that comprises a first optical waveguide 16. The first optical waveguide16 is configured to provide a first optical path length between the first optical output port 7 and the second optical input port 11. The second optical output port 8 of the first 1x2 MMI input splitter 4 and the third optical input port 12 of the first 2x2 MMI output splitter 9 are optically interconnected via a second optical guiding structure 17 that comprises a second optical waveguide 18. The second optical waveguide 18 is configured to provide a second optical path length between the second optical output port 8 and the third optical input port 12. In accordance with the first exemplary, non-limiting embodiment of the semiconductor tunable ring laser 1 shown in figure 1, the second optical path length is shorter than the first optical path length because the second optical waveguide 18 is shorter than the first optical waveguide 16. Because of the difference between the first optical path length and the second optical path length, the first MZI-based tunable frequency filter section 3a can be construed as an asymmetric MZI-based tunable frequency filter section. The person skilled in the art will appreciate that the above-described implementation of a difference between the first optical path length and the second optical path length, i.e. by applying a first optical guiding structure 15 and a second optical guiding structure 17 that respectively comprise a first optical waveguide 16 and a second optical waveguide 18 having different lengths, is just a non-limiting example. Another non-limiting example (not shown) of how to implement a difference between the first optical path length and the second optical path length is to apply a first optical guiding structure 15 and a second optical guiding structure 17 that respectively comprise a first optical waveguide 16 and a second optical waveguide 18 having equal lengths, wherein the first optical guiding structure 15 further comprises a ring-like structure that is optically associated with the first optical waveguide 16 in order to establish a ringloaded structure that gives rise to a first optical path length provided by the first optical guiding structure 15 that is different from the second optical path length provided by the second optical guiding structure 17.

The second multimode waveguide section 10 of the first 2x2 MMI output splitter 9 is configured to achieve an x/(100-x) split ratio with x having a value that is unequal to 50. On the one hand, the x/(100-x) split ratio is chosen to enable, if the semiconductor tunable ring laser 1 is in use and irrespective of a phase relationship between optical radiation at the second optical input port 11 of the first 2x2 MMI output splitter 9 and optical radiation at the third optical input port 12 of the first 2x2 MMI output splitter 9, that a first non-zero fraction, T₁, of optical radiation of an amount of optical radiation, T₀, that is incident on the second optical input port 11 and on the third optical input port 12 is present at the fourth optical output port 14 of the first 2x2 MMI output splitter 9, wherein the first non-zero fraction, T₁, of optical radiation is sufficient to enable wavelength locking and/or power monitoring outside of the laser cavity 2. On the other hand, the x/(100-x) split ratio is chosen to enable, if the semiconductor tunable ring laser 1 is in use and irrespective of a phase relationship between optical radiation at the second optical input port 11 and optical radiation at the third optical input port 12, that a second fraction, T₂=1-T₁, of optical radiation of the amount of optical radiation, T₀, is present at the third optical output port 13 of the first 2x2 MMI output splitter 9. In this way, the second fraction, T₂=1-T₁, of optical radiation remains in the closed loop optical path of the laser cavity.

As mentioned above, the value of x can be in a range from 64 to 80. In this way, the x/(100-x) split ratio of the first 2x2 MMI output splitter can range from 64/36 to 80/20. As a result, the first MZI-based tunable frequency filter section has a maximum transmission that can range from 85% to 99% and a minimum transmission that can range from 1% to 15%. In an exemplary embodiment of the semiconductor tunable ring laser according to the invention, the value of x is 72. In this case, the split ratio of the first 2x2 MMI output splitter is 72/28, and the first MZI-based tunable frequency filter section has a maximum transmission of 95% and a minimum transmission of 5%.

The second MZI-based tunable frequency filter section 3b of the optical filter 3 shown in figure 1, comprises a second 1x2 MMI input splitter 19 comprising a third multimode waveguide section 20 that is configured to achieve a 50/50 split ratio. The third multimode waveguide section 20 is provided with a fourth optical input port 21, a fifth optical output port 22, and a sixth optical output port 23. The fourth optical input port 21 is arranged in optical communication with the third optical output port 13 of the first 2x2 MMI output splitter 9 of the first MZI-based tunable frequency filter section 3a. In this way, the fourth optical input port 21 is arranged in optical communication with the closed loop optical path of the laser cavity 2.

The second MZI-based tunable frequency filter section 3b further comprises a first 2x1 MMI output combiner 24 comprising a fourth multimode waveguide section 25 that is configured to a achieve a 50/50 combining ratio. The fourth multimode waveguide section 25 is provided with a fifth optical input port 26, a sixth optical input port 27, and a seventh optical output port 28 that is arranged in optical communication with the closed loop optical path of the laser cavity 2. The fifth optical output port 22 of the second 1x2 MMI input splitter 19 and the fifth optical input port 26 of the first 2x1 MMI output combiner 24 are optically interconnected via a third optical guiding structure 29 that comprises a third optical waveguide 30. The third optical waveguide 30 is configured to provide a third optical path length between the fifth optical output port 22 and the fifth optical input port 26. The sixth optical output port 23 of the second 1x2 MMI input splitter 19 and the sixth optical input port 27 of the first 2x1 MMI output combiner 24 are optically interconnected via a fourth optical guiding structure 31 comprising a fourth optical waveguide 32. The fourth optical waveguide 32 is configured to provide a fourth optical path length between the sixth optical output port 23 and the sixth optical input port 27. In accordance with the first exemplary, non-limiting embodiment of the semiconductor tunable ring laser 1 shown in figure 1, the fourth optical path length is shorter than the third optical path length because the fourth optical waveguide 32 is shorter than the third optical waveguide 30. Because of the difference between the fourth optical path length and the third optical path length, the second MZI-based tunable frequency filter section 3b can be construed as an asymmetric MZI-based tunable frequency filter section. The person skilled in the art will appreciate that the above-mentioned consideration regarding the way in which a difference between optical path lengths can be established applies mutatis mutandis.

The third MZI-based tunable frequency filter section 3c of the optical filter 3 shown in figure 1, comprises a third 1x2 MMI input splitter 33 comprising a fifth multimode waveguide section 34 that is configured to achieve a 50/50 split ratio.

The third multimode waveguide section 34 is provided with a seventh optical input port 35, an eighth optical output port 36, and a ninth optical output port 37. The seventh optical input port 35 is arranged in optical communication with the seventh optical output port 28 of the first 2x1 MMI output combiner 24 of the second MZI-based tunable frequency filter section 3b. In this way, the seventh optical input port 35 is arranged in optical communication with the closed loop optical path of the laser cavity 2.

The third MZI-based tunable frequency filter section 3c further comprises a second 2x1 MMI output combiner 38 comprising a sixth multimode waveguide section 39 that is configured to a achieve a 50/50 combining ratio. The sixth multimode waveguide section 39 is provided with an eighth optical input port 40, a ninth optical input port 41, and a tenth optical output port 42 that is arranged in optical communication with the closed loop optical path of the laser cavity 2. The eighth optical output port 36 of the third 1x2 MMI input splitter 33 and the eighth optical input port 40 of the second 2x1 MMI output combiner 38 are optically interconnected via a fifth optical guiding structure 43 that comprises a fifth optical waveguide 44. The fifth optical waveguide 44 is configured to provide a fifth optical path length between the eighth optical output port 36 and the eighth optical input port 40. The ninth optical output port 37 of the third 1x2 MMI input splitter 33 and the ninth optical input port 41 of the second 2x1 MMI output combiner 38 are optically interconnected via a sixth optical guiding structure 45 that comprises a sixth optical waveguide 46. The sixth optical waveguide 46 is configured to provide a sixth optical path length between the ninth optical output port 37 and the ninth optical input port 41. In accordance with the first exemplary, non-limiting embodiment of the semiconductor tunable ring laser 1 shown in figure 1, the sixth optical path length is shorter than the fifth optical path length because the sixth optical waveguide 46 is shorter than the fifth optical waveguide 44. Because of the difference between the sixth optical path length and the fifth optical path length, the third MZI-based tunable frequency filter section 3c can be construed as an asymmetric MZI-based tunable frequency filter section. The person skilled in the art will appreciate that the above-mentioned consideration regarding the way in which a difference between optical path lengths can be established applies mutatis mutandis.

In accordance with the first, non-exemplary embodiment of the semiconductor tunable ring laser 1 shown in figure 1, the closed loop optical path of the laser cavity 2 is provided with a gain section 47 comprising a tenth optical input port 48 and an eleventh optical output port 49. The tenth optical input port 48 is arranged in optical communication with the tenth optical output port 42 of the second 2x1 MMI output combiner 38 of the third MZI-based tunable frequency filter section 3c. In this way, the tenth optical input port 48 is arranged in optical communication with the closed loop optical path of the laser cavity 2.

The closed loop optical path of the laser cavity 2 is further provided with a second 2x2 MMI output splitter 50 comprising a seventh multimode waveguide section 51 that is provided with an eleventh optical input port 52 that is arranged in optical communication with the eleventh optical output port 49 of the gain section 47 and thereby in optical communication with the closed loop optical path of the laser cavity 2. The seventh multimode waveguide section 51 is further provided with a twelfth optical input port 53, a twelfth optical output port 55, and a thirteenth optical output port 56. The twelfth optical input port 53 is arranged in optical communication with an optical reflector 54 that is arranged outside the closed loop optical path of the laser cavity 2. The twelfth optical output port 55 is arranged in optical communication with the first optical input port 6 of the first 1x2 MMI input splitter 4 of the first MZI-based tunable frequency filter section 3a and thereby in optical communication with the closed loop optical path of the laser cavity 2. The thirteenth optical output port 56 is configured and arranged to enable optical power to be coupled out of the laser cavity 2 for being used in an application other than wavelength locking and/or power monitoring purposes. The second 2x2 MMI output splitter 50 can be configured to have any suitable split ratio depending on the requirements of an application the semiconductor tunable ring laser 1 according to the present invention is used in.

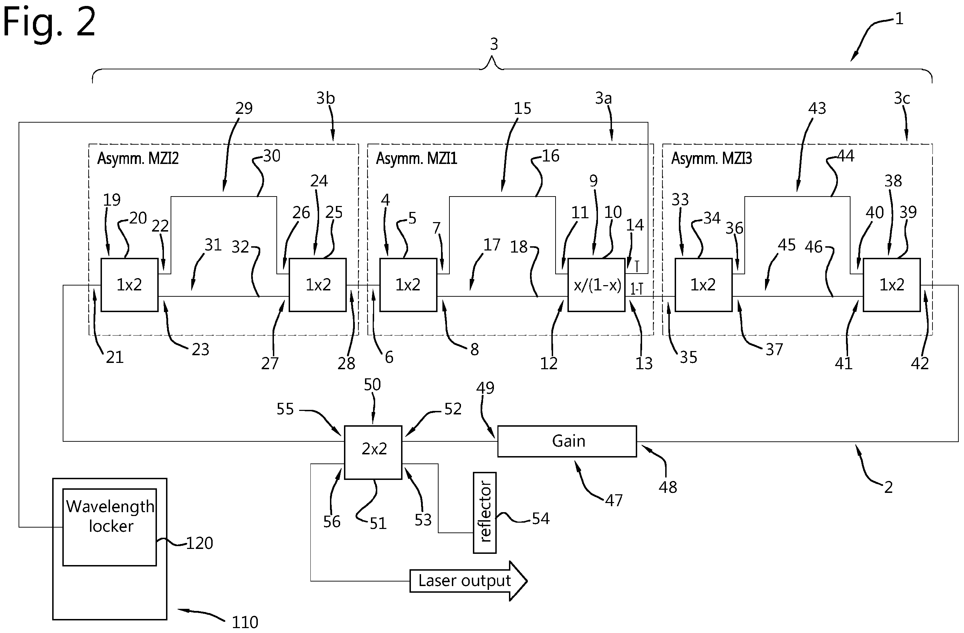

Figure 2 shows a schematic top view of a second exemplary, non-limiting embodiment of the semiconductor tunable ring laser 1 according to the present invention that comprises a laser cavity 2 having a closed loop optical path and an optical filter 3 that is arranged within the laser cavity 2. The optical filter 3 is configured as a transmission-type optical filter if the semiconductor tunable ring laser 1 is in use. The optical filter 3 comprises the first MZI-based tunable frequency filter section 3a, the second MZI-based tunable frequency filter section 3b and the third MZI-based tunable frequency filter section 3c as shown in figure 1. However, the order in which the three MZI-based tunable frequency filter sections are arranged in a series configuration inside the laser cavity 2 is different. In accordance with the second exemplary, non-limiting embodiment of the semiconductor tunable ring laser 1 shown in figure 2, the first MZI-based tunable frequency filter section 3a is arranged in between the second MZI-based tunable frequency filter section 3b and the third MZI-based tunable frequency filter section 3c. The person skilled in the art will appreciate that the number of MZI-based tunable frequency filter sections is exemplary and non-limiting. Depending on the specific requirements the semiconductor tunable ring laser needs to meet, any suitable number, e.g. 1, 2, 3, 4, 5, 6, etc., can be envisaged.

In accordance with the second exemplary, non-limiting embodiment of the semiconductor tunable ring laser 1 shown in figure 2, the fourth optical input port 21 of the second 1x2 MMI input splitter 19 of the second MZI-based tunable frequency filter section 3b is arranged in optical communication with the closed loop optical path of the laser cavity 2. The seventh optical output port 28 of the first 2x1 MMI output combiner 24 of the second MZI-based tunable frequency filter section 3b is arranged in optical communication with the first optical input port 6 of the first 1x2 MMI input splitter 4 of the first MZI-based tunable frequency filter section 3a.

The third optical output port 13 of the first 2x2 MMI output splitter 9 of the first MZI-based tunable frequency filter section 3a is arranged in optical communication with the seventh optical input port 35 of the third 1x2 MMI input splitter 33 of the third MZI-based tunable frequency filter section 3c. The fourth optical output port 14 of the first 2x2 MMI output splitter 9 of the first MZI-based tunable frequency filter section 3a is configured and arranged as the optical monitoring port of the laser cavity 2. In accordance with the second exemplary, non-limiting embodiment of the semiconductor tunable ring laser 1 shown in figure 2, the fourth optical output port 14 is arranged in optical communication with the wavelength locker 120 of the optical radiation monitoring assembly 110.

The tenth optical output port 42 of the second 2x1 MMI output combiner 38 of the third MZI-based tunable frequency filter section 3c is arranged in optical communication with the tenth optical input port 48 of the gain section 47. The twelfth optical output port 55 of the second 2x2 MMI output splitter 50 is arranged in optical communication with the fourth optical input port 21 of the second 1x2 MMI input splitter 19 of the second MZI-based tunable frequency filter section 3b.

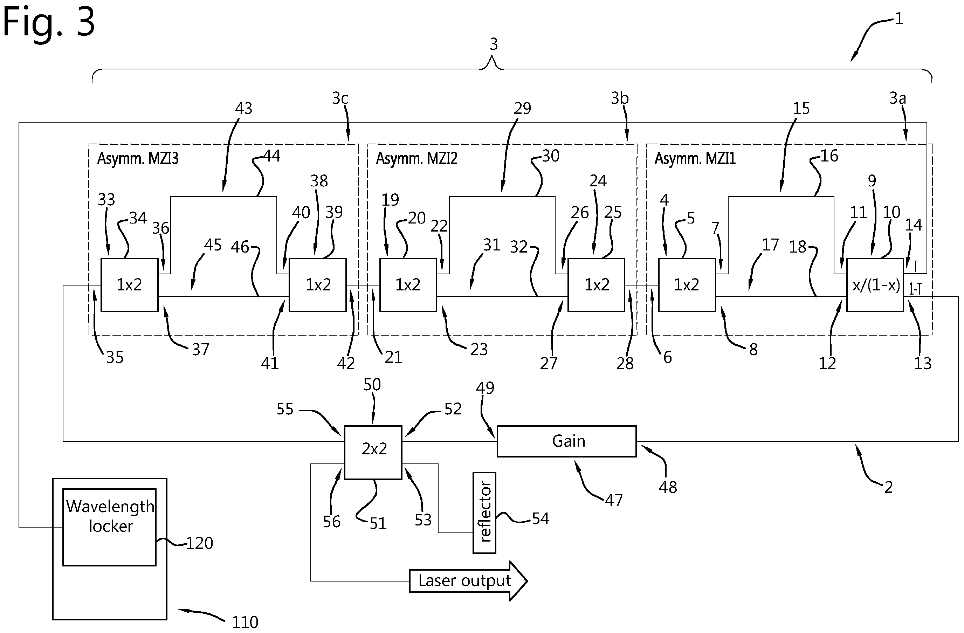

Figure 3 shows a schematic top view of a third exemplary, non-limiting embodiment of the semiconductor tunable ring laser 1 according to the present invention that comprises a laser cavity 2 having a closed loop optical path and an optical filter 3 that is arranged within the laser cavity 2. The optical filter 3 is configured as a transmission-type optical filter if the semiconductor tunable ring laser 1 is in use. The optical filter 3 comprises the first MZI-based tunable frequency filter section 3a, the second MZI-based tunable frequency filter section 3b and the third MZI-based tunable frequency filter section 3c as shown in figures 1 and 2. However, the order in which the three MZI-based tunable frequency filter sections are arranged in a series configuration inside the laser cavity 2 is different. In accordance with the third exemplary, non-limiting embodiment of the semiconductor tunable ring laser 1 shown in figure 3, the order of the MZI-based tunable frequency filter sections has been reversed as compared to the order of the MZI-based tunable frequency filter sections shown in figure 1, i.e. as seen from left to right, the third MZI-based tunable frequency filter section 3c is followed by the second MZI-based tunable frequency filter section 3b which is followed by the first MZI-based tunable frequency filter section 3a. The person skilled in the art will appreciate that the number of MZI-based tunable frequency filter sections is exemplary and non-limiting. Depending on the specific requirements the semiconductor tunable ring laser needs to meet, any suitable number, e.g. 1, 2, 3, 4, 5, 6, etc., can be envisaged.

In accordance with the third exemplary, non-limiting embodiment of the semiconductor tunable ring laser 1 shown in figure 3, the seventh optical input port 35 of the third 1x2 MMI input splitter 33 of the third MZI-based tunable frequency filter section 3c is arranged in optical communication with the closed loop optical path of the laser cavity 2. The tenth optical output port 42 of the second 2x1 MMI output combiner 38 of the third MZI-based tunable frequency filter section 3c is arranged in optical communication with the fourth optical input port 21 of the second 1x2 MMI input splitter 19 of the second MZI-based tunable frequency filter section 3b. The seventh optical output port 28 of the first 2x1 MMI output combiner 24 of the second MZI-based tunable frequency filter section 3b is arranged in optical communication with the first optical input port 6 of the first 1x2 MMI input splitter 4 of the first MZI-based tunable frequency filter section 3a.

The third optical output port 13 of the first 2x2 MMI output splitter 9 of the first MZI-based tunable frequency filter section 3a is arranged in optical communication with the tenth optical input port 48 of the gain section 47. The fourth optical output port 14 of the first 2x2 MMI output splitter 9 of the first MZI-based tunable frequency filter section 3a is configured and arranged as the optical monitoring port of the laser cavity 2. In accordance with the third exemplary, non-limiting embodiment of the semiconductor tunable ring laser 1 shown in figure 3, the fourth optical output port 14 is arranged in optical communication with the wavelength locker 120 of the optical radiation monitoring assembly 110. The twelfth optical output port 55 of the second 2x2 MMI output splitter 50 is arranged in optical communication with the seventh optical input port 35 of the third 1x2 MMI input splitter 33 of the third MZI-based tunable frequency filter section 3c.

The person skilled in the art will appreciate that each one of the three above-described exemplary non-limiting embodiments of the semiconductor tunable ring laser 1 according to the present invention enables tapping off the first non-zero fraction, T₁, of optical radiation directly from within the laser cavity 2 instead of after or outside of the laser cavity, i.e. from an amount of optical radiation constituting a main optical output of a semiconductor tunable ring laser, as is done in semiconductor tunable ring lasers known in the art. As mentioned above, the semiconductor tunable ring laser 1 according to the present invention has an improved overall efficiency compared to semiconductor tunable ring lasers known in the art despite tapping off the first non-zero fraction, T₁, of optical radiation and any optical losses related to lasing wavelength stabilization purposes.

For each one of the three above-described exemplary non-limiting embodiments of the semiconductor tunable ring laser 1 according to the present invention, the first MZI-based tunable frequency filter section 3a is configured to have a first free spectral range, the second MZI-based tunable frequency filter section 3b is configured to have a second free spectral range, and the third MZI-based tunable frequency filter section 3c is configured to have a third free spectral range. The first free spectral range, the second free spectral range, and the third free spectral range are different from each other. In this way, the stability of the semiconductor tunable ring laser 1 according to the present invention can be improved.

Furthermore, each one of the three above-described exemplary non-limiting embodiments of the semiconductor tunable ring laser 1 according to the present invention can be implemented as an InP-based tunable ring laser. As mentioned above, InP-based semiconductor materials are the semiconductor materials of choice for fabricating a semiconductor tunable ring laser that can be used for example, but not exclusively, in telecommunication applications, Light Detection and Ranging (LIDAR) or sensor applications. InP-based technology enables monolithic integration of both active components such as for example light-generating and/or light-absorbing optical devices, and passive components such as for example light-guiding and/or light-switching optical devices, in one PIC on a single die.

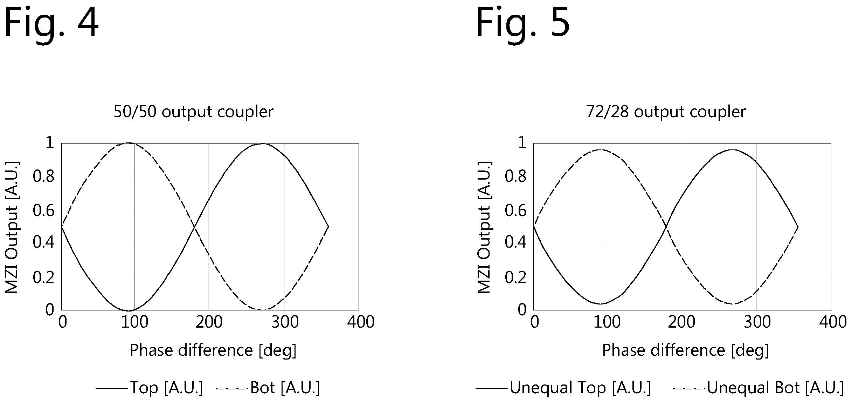

Figure 4 shows a schematic representation of an output transmission as a function of phase difference of an MZI-based tunable frequency filter section that comprises a 1x2 MMI input splitter that is configured to achieve a 50/50 split ratio and a 2x1 MMI output combiner that is configured to achieve a 50/50 combining ratio. The person skilled in the art will appreciate that the output transmission versus phase difference diagram shown in figure 4 holds for the second MZI-based tunable frequency filter section 3b and the third MZI-based tunable frequency filter section 3c shown in figures 1, 2 and 3. For the sake of conversation the second MZI-based tunable frequency filter section 3b is referred to in the following explanation. Figure 4 shows that for a 180 degree phase difference between the third optical guiding structure 29 and the fourth optical guiding structure 31 full transmission is achieved to the fourth optical guiding structure 31 and no transmission is achieved to the third optical guiding structure 29. In an attempt to use the second MZI-based tunable frequency filter section 3b for tapping radiation from the laser cavity 2, the second MZI-based tunable frequency filter section 3b must be biased slightly away from this point, i.e. the 180 degree phase difference between the third optical guiding structure 29 and the fourth optical guiding structure 31. This requires a control loop that must not interfere with any other control loops already running, for example a control loop for stabilizing the lasing wavelength of the semiconductor tunable ring laser. As mentioned above, an insight of the present invention is that the coupling ratios of the MMI output combiner can be chosen in such a way to guarantee that at least a minimum amount of light will always reach a tap port or monitoring port.

In accordance with the above-mentioned insight, the x/(100-x) split ratio, with x having a value that is unequal to 50, of the first 2x2 MMI output splitter 9 of the first MZI-based tunable frequency filter section 3a shown in figures 1-3, enables the first non-zero fraction, T₁, of optical radiation to always be present at the fourth optical output port 14 of the first 2x2 MMI output splitter 9 irrespective of the phase relationship between optical radiation at the second optical input port 11 of the first 2x2 MMI output splitter 9 and optical radiation at the third optical input port 12 of the first 2x2 MMI output splitter 9. An advantage of the above-mentioned insight is that a control loop for ensuring that a minimum amount of optical radiation is available for wavelength locking and/or power monitoring outside of the laser cavity is no longer required. As a result, less components are required for achieving lasing wavelength stabilization for a semiconductor tunable ring laser 1 according to the present invention compared to semiconductor tunable ring lasers known in the art. To enable wavelength locking and/or power monitoring outside of the laser cavity, the first non-zero fraction, T₁, of optical radiation is sufficient if the first non-zero fraction, T₁, of optical radiation is for example in a range from 1% to 15% of the amount of optical radiation, T₀, that is incident on the second optical input port 11 of the first 2x2 MMI output splitter 9 and on the third optical input port 12 of the first 2x2 MMI output splitter 9.

Figure 5 shows a schematic representation of an output transmission as a function of phase difference of an MZI-based tunable frequency filter section that comprises a 1x2 MMI input splitter that is configured to achieve a 50/50 split ratio and a 2x2 MMI output splitter that is configured to have a 72/28 split ratio. The person skilled in the art will appreciate that the above-mentioned MZI-based tunable frequency filter section can be implemented as an exemplary non-limiting embodiment of the first MZI-based tunable frequency filter section 3a of the semiconductor tunable ring laser 1 according to the present invention. Having regard to any one of the figures 1-3, it will be clear that the 1x2 MMI input splitter having the 50/50 split ratio corresponds to the first 1x2 MMI input splitter 4 of the first MZI-based tunable frequency filter section 3a, and that the 2x2 MMI output splitter having the 72/28 split ratio corresponds to the first 2x2 MMI output splitter 9 of the first MZI-based tunable frequency filter section 3a.

Figure 5 shows that for a 180 degree phase difference between the first optical guiding structure 15 and the second optical guiding structure 17 of the first MZI-based tunable frequency filter section 3a a maximum transmission of 95% is achieved to the second optical guiding structure 17 and a minimum transmission of 5% is always achieved to the first optical guiding structure 15. In this way, a control loop for ensuring that a minimum amount of light reaches the wavelength locker 120 is no longer required because it can be guaranteed by design that at least 5% of the optical radiation that is incident on the second optical input port 11 of the first 2x2 MMI output splitter 9 and on the third optical input port 12 of the first 2x2 MMI output splitter 9 reaches the wavelength locker 120 that is arranged in optical communication with the fourth optical output port 14 of the first 2x2 MMI output splitter 9 that serves as an optical monitoring port of the laser cavity 2.

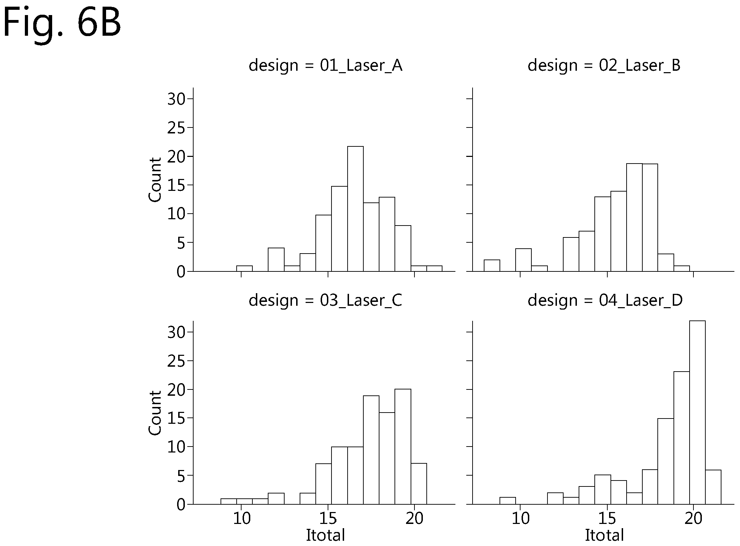

As mentioned above, by tapping off the first non-zero fraction, T₁, of optical radiation directly from within the laser cavity 2 at the fourth optical output port 14 of the first 2x2 MMI output splitter 9, the use of a lossy coupler that is arranged after or outside of the laser cavity 2, which is done in semiconductor tunable ring lasers known in the art, can be avoided. Wafer probe measurements have shown that the omission of the above-mentioned lossy couplers results in a reduction of overall optical losses of the semiconductor tunable ring laser 1 according to the present invention. Figure 6A shows a comparison of total optical output powers for three semiconductor tunable ring lasers A, B and C known in the art, wherein each of these known semiconductor tunable ring lasers comprises a conventional 85/15 output splitter that is arranged after or outside of the laser cavity to provide optical radiation that can be used for lasing wavelength stabilization purposes, and a semiconductor tunable ring laser D according to the present invention, wherein the laser cavity is directly tapped using a 2x2 MMI output splitter that is configured to achieve a 72/28 split ratio to provide optical radiation that can be used for lasing wavelength stabilization purposes. Figure 6A shows that the optical output power for the semiconductor tunable ring laser D according to the present invention is higher than the respective optical output powers of the known semiconductor tunable ring lasers A, B and C, respectively. This is not simply because a smaller non-zero fraction, T₁, of optical radiation is tapped off in the case of the semiconductor tunable ring laser D according to the present invention compared to the respective non-zero fractions, T₁, of optical radiation that are tapped off in the case of the known semiconductor tunable ring lasers A, B and C, because the total photo-induced electrical current of the semiconductor tunable ring laser D, which is the sum of the photo-induced electrical current as a result of the main optical output of the semiconductor tunable ring laser D and the photo-induced electrical current as a result of the first non-zero fraction, T₁, of optical radiation directed to an optical sensor of a control circuit for stabilizing the lasing wavelength, is higher than the respective total photo-induced electrical currents of the known semiconductor tunable ring lasers A, B and C. This is shown in figure 6B.

Having regard to figures 6A and 6B, the person skilled in the art will appreciate that tapping off the first non-zero fraction, T₁, of optical radiation directly from within the laser cavity results in a reduction of overall optical losses of the semiconductor tunable ring laser D according to the present invention compared to the overall optical losses of the three known semiconductor tunable ring lasers A, B, and D from which the first non-zero fraction, T₁, of optical radiation is tapped off after or outside of the laser cavity. Hence, the semiconductor tunable ring laser D according to the present invention has an improved overall efficiency compared to the three known semiconductor tunable ring lasers A, B and C.

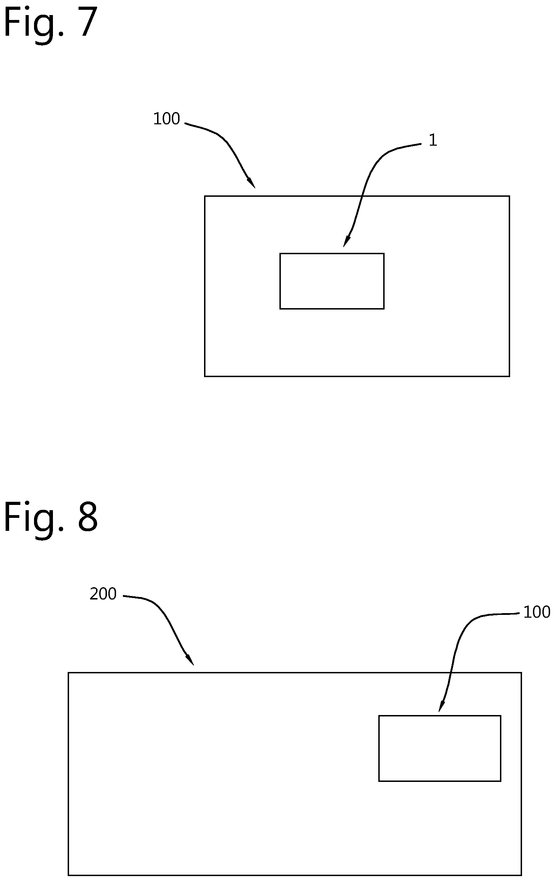

Figure 7 shows a schematic top view of a first exemplary, non-limiting embodiment of a PIC 100 according to the present invention that comprises the semiconductor tunable ring laser 1 according to the present invention. The semiconductor tunable ring laser 1 can be construed to be monolithically integrated with the other opto-electronic devices (not shown) of the PIC 100.

In accordance with an exemplary, non-limiting embodiment of the PIC that is not shown, the semiconductor tunable ring laser can be integrated in a hybrid way with the other opto-electronic devices of the PIC. An advantage of enabling hybrid integration of the semiconductor tunable ring laser according to the invention is that the semiconductor tunable ring laser can be used in any semiconductor technology domain such as the domain of silicon photonics. Another advantage of enabling hybrid integration of the semiconductor tunable ring laser according to the invention is that the semiconductor tunable ring laser can be exchanged. Exchange of the semiconductor tunable ring laser can be required for example in case of malfunction of the laser or after breakdown of the laser.

An advantage of monolithically integrating the semiconductor tunable ring laser with other opto-electronic devices (not shown) on the same semiconductor substrate as schematically illustrated in figure 7, is that the monolithic integration of the semiconductor tunable ring laser 1 and the other opto-electronic components can be less cumbersome and possibly requires less die area than the hybrid integration thereof. Consequently, the costs associated with monolithic integration of the active and the passive opto-electronic devices can be less than the costs associated with the hybrid integration thereof. In addition, monolithic integration can allow the PIC 100 to have a smaller footprint. This is beneficial for reducing the costs of the PIC.

The PIC 100 can be an InP-based PIC. The person skilled in the art will appreciate that the most versatile technology platform for PICs, especially for PICs that can be applied in telecommunication, LIDAR or sensor applications, uses wafers comprising InP-based semiconductor materials. InP-based technology enables monolithic integration of both active components such as for example light-generating and/or light-absorbing optical devices, and passive components such as for example light-guiding and/or light-switching optical devices, in one PIC on a single die.

Based on the above, the person skilled in the art will appreciate that the PIC 100 according to the invention can benefit from the advantages provided by the semiconductor tunable ring laser 1 according to the present invention.

Figure 8 shows a schematic view of a first exemplary, non-limiting embodiment of an opto-electronic system 200 according to the present invention that comprises a PIC 100 according to the present invention. The opto-electronic system 200 can be used for example but not exclusively in telecommunication applications, LIDAR or sensor applications. The opto-electronic system 200 can for example be one of a transmitter, a receiver, a transceiver, a coherent transmitter, a coherent receiver and a coherent transceiver. Based on the above, the person skilled in the art will appreciate that the opto-electronic system 200 according to the present invention can benefit from the advantages provided by the PIC 100 according to the present invention.

The present invention can be summarized as relating to a semiconductor tunable ring laser 1 comprising a laser cavity 2 having a closed loop optical path, and an optical filter 3 that is arranged within the laser cavity 2 and configured as a transmission-type optical filter if the semiconductor tunable ring laser 1 is in use. The optical filter 3 comprises a first MZI-based tunable frequency filter section 3a comprising a first 2x2 MMI output splitter 9 having an x/(100-x) split ratio with x being unequal to 50. The first 2x2 MMI output splitter 9 provides the laser cavity 2 with an optical monitoring port that is presented with a first non-zero fraction, T₁, of optical radiation that is sufficient for wavelength locking and/or power monitoring outside the laser cavity 2. The invention also relates to a PIC 100 comprising a semiconductor tunable ring laser 1 according to the invention, and to an opto-electronic system 200 comprising such a PIC 100.

It will be clear to a person skilled in the art that the scope of the present invention is not limited to the examples discussed in the foregoing but that several amendments and modifications thereof are possible without deviating from the scope of the present invention as defined by the attached claims. In particular, combinations of specific features of various aspects of the invention may be made. An aspect of the invention may be further advantageously enhanced by adding a feature that was described in relation to another aspect of the invention. While the present invention has been illustrated and described in detail in the figures and the description, such illustration and description are to be considered illustrative or exemplary only, and not restrictive.

The present invention is not limited to the disclosed embodiments. Variations to the disclosed embodiments can be understood and effected by a person skilled in the art in practicing the claimed invention, from a study of the figures, the description and the attached claims. In the claims, the word "comprising" does not exclude other steps or elements, and the indefinite article "a" or "an" does not exclude a plurality. The mere fact that certain measures are recited in mutually different dependent claims does not indicate that a combination of these measures cannot be used to advantage. Any reference numerals in the claims should not be construed as limiting the scope of the present invention.

## Claims

1. A semiconductor tunable ring laser (1) comprising:
- a laser cavity (2) having a closed loop optical path; and
- an optical filter (3) that is arranged within the laser cavity (2) and is configured as a transmission-type optical filter if the semiconductor tunable ring laser (1) is in use, the optical filter (3) comprising:
• a first MZI-based tunable frequency filter section (3a) that comprises:
∘ a first 1x2 MMI input splitter (4) comprising a first multimode waveguide section (5) that is provided with:
∘ a first optical input port (6) that is arranged in optical communication with the closed loop optical path of the laser cavity (2);
∘ a first optical output port (7); and
∘ a second optical output port (8);
the first multimode waveguide section (5) being configured to achieve a 50/50 split ratio;
∘ a first 2x2 MMI output splitter (9) comprising a second multimode waveguide section (10) that is provided with:
∘ a second optical input port (11);
∘ a third optical input port (12);
∘ a third optical output port (13) that is arranged in optical communication with the closed loop optical path of the laser cavity (2); and
∘ a fourth optical output port (14) that is configured and arranged as an optical monitoring port of the laser cavity (2);
∘ a first optical guiding structure (15) comprising a first optical waveguide (16) that is arranged to optically interconnect the first optical output port (7) of the 1x2 MMI input splitter (4) and the second optical input port (11) of the first 2x2 MMI output splitter (9), the first optical guiding structure (15) being configured to provide a first optical path length between the first optical output port (7) of the first 1x2 MMI input splitter (4) and the second optical input port (11) of the first 2x2 MMI output splitter (9); and
∘ a second optical guiding structure (17) comprising a second optical waveguide (18) that is arranged to optically interconnect the second optical output port (8) of the first 1x2 MMI input splitter (4) and the third optical input port (12) of the first 2x2 MMI output splitter (9), the second optical guiding structure (17) being configured to provide a second optical path length between the second optical output port (8) of the first 1x2 MMI input splitter (4) and the third optical input port (12) of the first 2x2 MMI output splitter (9), the second optical path length being different than the first optical path length;
wherein the second multimode waveguide section (10) of the first 2x2 MMI output splitter (9) is configured to achieve an x/(100-x) split ratio with x having a value that is unequal to 50, the x/(100-x) split ratio being chosen to enable, if the semiconductor tunable ring laser (1) is in use and irrespective of a phase relationship between optical radiation at the second optical input port (11) of the first 2x2 MMI output splitter (9) and optical radiation at the third optical input port (12) of the first 2x2 MMI output splitter (9):
▪ a first non-zero fraction, T₁, of optical radiation of an amount of optical radiation, T₀, that is incident on the second optical input port (11) of the first 2x2 MMI output splitter (9) and on the third optical input port (12) of the first 2x2 MMI output splitter (9) to be present at the fourth optical output port (14) of the first 2x2 MMI output splitter (9), the first non-zero fraction, T₁, of optical radiation being sufficient to enable wavelength locking and/or power monitoring outside of the laser cavity (2); and
▪ a second fraction, T₂=1-T₁, of optical radiation of the amount of optical radiation, T₀, to be present at the third optical output port (13) of the first 2x2 MMI output splitter (9) and thereby remaining in the closed loop optical path of the laser cavity (2).

2. The semiconductor tunable ring laser (1) according to claim 1, wherein the value of x is in a range from 64 to 80.

3. The semiconductor tunable ring laser (1) according to claim 1 or 2, wherein the optical filter (3) comprises a second MZI-based tunable frequency filter section (3b) comprising:
- a second 1x2 MMI input splitter (19) comprising a third multimode waveguide section (20) that is provided with:
• a fourth optical input port (21) that is arranged in optical communication with the third optical output port (13) of the first 2x2 MMI output splitter (9) of the first MZI-based tunable frequency filter section (3a) and thereby in optical communication with the closed loop optical path of the laser cavity (2);
• a fifth optical output port (22); and
• a sixth optical output port (23);
the third multimode waveguide section (20) being configured to achieve a 50/50 split ratio;
- a first 2x1 MMI output combiner (24) comprising a fourth multimode waveguide section (25) that is provided with:
• a fifth optical input port (26);
• a sixth optical input port (27); and
• a seventh optical output port (28) that is arranged in optical communication with the closed loop optical path of the laser cavity (2);
- a third optical guiding structure (29) comprising a third optical waveguide (30) that is arranged to optically interconnect the fifth optical output port (22) of the second 1x2 MMI input splitter (19) and the fifth optical input port (26) of the first 2x1 MMI output combiner (24), the third optical guiding structure (29) being configured to provide a third optical path length between the fifth optical output port (22) of the second 1x2 MMI input splitter (19) and the fifth optical input port (26) of the first 2x1 MMI output combiner (24); and
- a fourth optical guiding structure (31) comprising a fourth optical waveguide (32) that is arranged to optically interconnect the sixth optical output port (23) of the second 1x2 MMI input splitter (19) and the sixth optical input port (27) of the first 2x1 MMI output combiner (24), the fourth optical guiding structure (31) being configured to provide a fourth optical path length between the sixth optical output port (23) of the second 1x2 MMI input splitter (19) and the sixth optical input port (27) of the first 2x1 MMI output combiner (24), the fourth optical path length being different than the third optical path length.

4. The semiconductor tunable ring laser (1) according to claim 3, wherein the optical filter (3) comprises a third MZI-based tunable frequency filter section (3c) comprising:
- a third 1x2 MMI input splitter (33) comprising a fifth multimode waveguide section (34) that is provided with:
• a seventh optical input port (35) that is arranged in optical communication with the seventh optical output port (28) of the first 2x1 MMI output combiner (24) of the second MZI-based tunable frequency filter section (3b) and thereby in optical communication with the closed loop optical path of the laser cavity (2);
• an eighth optical output port (36); and
• a ninth optical output port (37);
the fifth multimode waveguide section (34) being configured to achieve a 50/50 split ratio;
- a second 2x1 MMI output combiner (38) comprising a sixth multimode waveguide section (39) that is provided with:
• an eighth optical input port (40);
• a ninth optical input port (41); and
• a tenth optical output port (42) that is arranged in optical communication with the closed loop optical path of the laser cavity (2);
- a fifth optical guiding structure (43) comprising a fifth optical waveguide (44) that is arranged to optically interconnect the eighth optical output port (36) of the third 1x2 MMI input splitter (33) and the eighth optical input port (40) of the second 2x1 MMI output combiner (38), the fifth optical guiding structure (43) being configured to provide a fifth optical path length between the eighth optical output port (36) of the third 1x2 MMI input splitter (33) and the eighth optical input port (40) of the second 2x1 MMI output combiner (38); and
- a sixth optical guiding structure (45) comprising a sixth optical waveguide (46) that is arranged to optically interconnect the ninth optical output port (37) of the third 1x2 MMI input splitter (33) and the ninth optical input port (41) of the second 2x1 MMI output combiner (38), the sixth optical guiding structure (45) being configured to provide a sixth optical path length between the ninth optical output port (37) of the third 1x2 MMI input splitter (33) and the ninth optical input port (41) of the second 2x1 MMI output combiner (38), the sixth optical path length being different than the fifth optical path length.

5. The semiconductor tunable ring laser (1) according to claim 4, wherein the closed loop optical path of the laser cavity (2) is provided with:
- a gain section (47) comprising:
∘ a tenth optical input port (48) that is arranged in optical communication with the tenth optical output port (42) of the second 2x1 MMI output combiner (38) of the third MZI-based tunable frequency filter section (3c) and thereby in optical communication with the closed loop optical path of the laser cavity (2); and
∘ an eleventh optical output port (49); and
- a second 2x2 MMI output splitter (50) comprising a seventh multimode waveguide section (51) that is provided with:
∘ an eleventh optical input port (52) that is arranged in optical communication with the eleventh optical output port (49) of the gain section (47) and thereby in optical communication with the closed loop optical path of the laser cavity (2);
∘ a twelfth optical input port (53) that is arranged in optical communication with an optical reflector (54) that is arranged outside the closed loop optical path of the laser cavity (2);
∘ a twelfth optical output port (55) that is arranged in optical communication with the first optical input port (6) of the first 1x2 MMI input splitter (4) of the first MZI-based tunable frequency filter section (3a) and thereby in optical communication with the closed loop optical path of the laser cavity (2); and
∘ a thirteenth optical output port (56) that is configured and arranged to enable optical power to be coupled out of the laser cavity (2) for being used in an application other than wavelength locking and/or power monitoring purposes.

6. The semiconductor tunable ring laser (1) according to claim 1 or 2, wherein the optical filter (3) comprises a second MZI-based tunable frequency filter section (3b) comprising:
- a second 1x2 MMI input splitter (19) comprising a third multimode waveguide section (20) that is provided with:
• a fourth optical input port (21) that is arranged in optical communication with the closed loop optical path of the laser cavity (2);
• a fifth optical output port (22); and
• a sixth optical output port (23);
the third multimode waveguide section (20) being configured to achieve a 50/50 split ratio;
- a first 2x1 MMI output combiner (24) comprising a fourth multimode waveguide section (25) that is provided with:
• a fifth optical input port (26);
• a sixth optical input port (27); and
• a seventh optical output port (28) that is arranged in optical communication with the first optical input port (6) of the first 1x2 MMI input splitter (4) of the first MZI-based tunable frequency filter section (3a) and thereby in optical communication with the closed loop optical path of the laser cavity (2);
- a third optical guiding structure (29) comprising a third optical waveguide (30) that is arranged to optically interconnect the fifth optical output port (22) of the second 1x2 MMI input splitter (19) and the fifth optical input port (26) of the first 2x1 MMI output combiner (24), the third optical guiding structure (29) being configured to provide a third optical path length between the fifth optical output port (22) of the second 1x2 MMI input splitter (19) and the fifth optical input port (26) of the first 2x1 MMI output combiner (24); and
- a fourth optical guiding structure (31) comprising a fourth optical waveguide (32) that is arranged to optically interconnect the sixth optical output port (23) of the second 1x2 MMI input splitter (19) and the sixth optical input port (27) of the first 2x1 MMI output combiner (24), the fourth optical guiding structure (31) being configured to provide a fourth optical path length between the sixth optical output port (23) of the second 1x2 MMI input splitter (19) and the sixth optical input port (27) of the first 2x1 MMI output combiner (24), the fourth optical path length being different than the third optical path length.

7. The semiconductor tunable ring laser (1) according to claim 6, wherein the optical filter (3) comprises a third MZI-based tunable frequency filter section (3c) comprising:
- a third 1x2 MMI input splitter (33) comprising a fifth multimode waveguide section (34) that is provided with:
• a seventh optical input port (35) that is arranged in optical communication with the third optical output port (13) of the first 2x2 MMI output splitter (9) of the first MZI-based tunable frequency filter section (3a) and thereby in optical communication with the closed loop optical path of the laser cavity (2);
• an eighth optical output port (36); and
• a ninth optical output port (37);
the fifth multimode waveguide section (34) being configured to achieve a 50/50 split ratio;
- a second 2x1 MMI output combiner (38) comprising a sixth multimode waveguide section (39) that is provided with:
• an eighth optical input port (40);
• a ninth optical input port (41); and
• a tenth optical output port (42) that is arranged in optical communication with the closed loop optical path of the laser cavity (2);
- a fifth optical guiding structure (43) comprising a fifth optical waveguide (44) that is arranged to optically interconnect the eighth optical output port (36) of the third 1x2 MMI input splitter (33) and the eighth optical input port (40) of the second 2x1 MMI output combiner (38), the fifth optical guiding structure (43) being configured to provide a fifth optical path length between the eighth optical output port (36) of the third 1x2 MMI input splitter (33) and the eighth optical input port (40) of the second 2x1 MMI output combiner (38); and
- a sixth optical guiding structure (45) comprising a sixth optical waveguide (46) that is arranged to optically interconnect the ninth optical output port (37) of the third 1x2 MMI input splitter (33) and the ninth optical input port (41) of the second 2x1 MMI output combiner (38), the sixth optical guiding structure (45) being configured to provide a sixth optical path length between the ninth optical output port (37) of the third 1x2 MMI input splitter (33) and the ninth optical input port (41) of the second 2x1 MMI output combiner (38), the sixth optical path length being different than the fifth optical path length.

8. The semiconductor tunable ring laser (1) according to claim 7, wherein the closed loop optical path of the laser cavity (2) is provided with:
- a gain section (47) comprising:
∘ a tenth optical input port (48) that is arranged in optical communication with the tenth optical output port (42) of the second 2x1 MMI output combiner (38) of the third MZI-based tunable frequency filter section (3c) and thereby in optical communication with the closed loop optical path of the laser cavity (2); and
∘ an eleventh optical output port (49); and
- a second 2x2 MMI output splitter (50) comprising a seventh multimode waveguide section (51) that is provided with:
∘ an eleventh optical input port (52) that is arranged in optical communication with the eleventh optical output port (49) of the gain section (47) and thereby in optical communication with the closed loop optical path of the laser cavity (2);
∘ a twelfth optical input port (53) that is arranged in optical communication with an optical reflector (54) that is arranged outside the closed loop optical path of the laser cavity (2);
∘ a twelfth optical output port (55) that is arranged in optical communication with the fourth optical input port (21) of the second 1x2 MMI input splitter (19) of the second MZI-based tunable frequency filter section (3b) and thereby in optical communication with the closed loop optical path of the laser cavity (2); and
∘ a thirteenth optical output port (56) that is configured and arranged to enable optical power to be coupled out of the laser cavity (2) for being used in an application other than wavelength locking and/or power monitoring purposes.

9. The semiconductor tunable ring laser (1) according to claim 6, wherein the optical filter (3) comprises a third MZI-based tunable frequency filter section (3c) comprising:
- a third 1x2 MMI input splitter (33) comprising a fifth multimode waveguide section (34) that is provided with:
• a seventh optical input port (35) that is arranged in optical communication with the closed loop optical path of the laser cavity (2);
• an eighth optical output port (36); and
• a ninth optical output port (37);
the fifth multimode waveguide section (34) being configured to achieve a 50/50 split ratio;
- a second 2x1 MMI output combiner (38) comprising a sixth multimode waveguide section (39) that is provided with:
• an eighth optical input port (40);
• a ninth optical input port (41); and
• a tenth optical output port (42) that is arranged in optical communication with the fourth optical input port (21) of the second 1x2 MMI input splitter (19) of the second MZI-based tunable frequency filter section (3b) and thereby in optical communication with the closed loop optical path of the laser cavity (2);
- a fifth optical guiding structure (43) comprising a fifth optical waveguide (44) that is arranged to optically interconnect the eighth optical output port (36) of the third 1x2 MMI input splitter (33) and the eighth optical input port (40) of the second 2x1 MMI output combiner (38), the fifth optical guiding structure (43) being configured to provide a fifth optical path length between the eighth optical output port (36) of the third 1x2 MMI input splitter (33) and the eighth optical input port (40) of the second 2x1 MMI output combiner (38); and
- a sixth optical guiding structure (45) comprising a sixth optical waveguide (46) that is arranged to optically interconnect the ninth optical output port (37) of the third 1x2 MMI input splitter (33) and the ninth optical input port (41) of the second 2x1 MMI output combiner (38), the sixth optical guiding structure (45) being configured to provide a sixth optical path length between the ninth optical output port (37) of the third 1x2 MMI input splitter (33) and the ninth optical input port (41) of the second 2x1 MMI output combiner (38), the sixth optical path length being different than the fifth optical path length.

10. The semiconductor tunable ring laser (1) according to claim 9, wherein the closed loop optical path of the laser cavity (2) is provided with:
- a gain section (47) comprising:
∘ a tenth optical input port (48) that is arranged in optical communication with the third optical output port (13) of the first 2x2 MMI output splitter (9) of the first MZI-based tunable frequency filter section (3a) and thereby in optical communication with the closed loop optical path of the laser cavity (2); and
∘ an eleventh optical output port (49); and
- a second 2x2 MMI output splitter (50) comprising a seventh multimode waveguide section (51) that is provided with:
∘ an eleventh optical input port (52) that is arranged in optical communication with the eleventh optical output port (49) of the gain section (47) and thereby in optical communication with the closed loop optical path of the laser cavity (2);
∘ a twelfth optical input port (53) that is arranged in optical communication with an optical reflector (54) that is arranged outside the closed loop optical path of the laser cavity (2);
∘ a twelfth optical output port (55) that is arranged in optical communication with the seventh optical input port (35) of the third 1x2 MMI input splitter (33) of the third MZI-based tunable frequency filter section (3c) and thereby in optical communication with the closed loop optical path of the laser cavity (2); and
∘ a thirteenth optical output port (56) that is configured and arranged to enable optical power to be coupled out of the laser cavity (2) for being used in an application other than wavelength locking and/or power monitoring purposes.

11. The semiconductor tunable ring laser (1) according to claim 4 or 7 or 9, wherein the first MZI-based tunable frequency filter section (3a) is configured to have a first free spectral range, the second MZI-based tunable frequency filter section (3b) is configured to have a second free spectral range, and the third MZI-based tunable frequency filter section (3c) is configured to have a third free spectral range, the first free spectral range, the second free spectral range, and the third free spectral range being different from each other.

12. The semiconductor tunable ring laser (1) according to any one of the claims 1 to 11, wherein the semiconductor tunable ring laser (1) is an InP-based tunable ring laser.

13. A photonic integrated circuit, PIC, (100) comprising a semiconductor tunable ring laser (1) according to any one of the claims 1 to 12, wherein the PIC (100) is a hybrid integrated PIC or a monolithic integrated PIC.

14. The PIC (100) according to claim 13, wherein the PIC (100) comprises an optical radiation monitoring assembly (110) that is optically connected with the fourth optical output port (14) of the first 2x2 MMI output splitter (9) of the first MZI-based tunable frequency filter section (3a) of the optical filter (3) of the semiconductor tunable ring laser (1).

15. An opto-electronic system (200) comprising a PIC (100) according to claims 13 or 14, wherein the opto-electronic system (200) is one of a transmitter, a receiver, a transceiver, a coherent transmitter, a coherent receiver and a coherent transceiver.
